(19) Europäisches Patentamt

European Patent Office

Office européen des brevets

(11) Numéro de publication: **0 364 351 B1**

(12) **FASCICULE DE BREVET EUROPEEN**

(45) Date de publication de fascicule du brevet: **13.04.94**

(51) Int. Cl.5: **H01L 27/146**, H01L 27/144, H04N 5/217, H04N 3/15

(21) Numéro de dépôt: **89402786.1**

(22) Date de dépôt: **10.10.89**

(54) **Procédé de détection photoélectrique avec réduction de rémanence de photo-transistor, notamment de type NIPIN.**

(30) Priorité: **14.10.88 FR 8813540**

(43) Date de publication de la demande:
**18.04.90 Bulletin 90/16**

(45) Mention de la délivrance du brevet:
**13.04.94 Bulletin 94/15**

(84) Etats contractants désignés:
**DE FR GB NL**

(56) Documents cités:
**EP-A- 0 187 047**
**EP-A- 0 214 033**
**EP-A- 0 222 624**
**US-A- 4 633 287**
**US-A- 4 737 832**

**PATENT ABSTRACTS OF JAPAN, vol. 11, no. 148 (E-506)[2595], 14 mai 1987, page 51 E 506 ; & JP-A-61 285 759 (CANON INC.) 16-12-1986**

(73) Titulaire: **THOMSON-CSF**
**173, Boulevard Haussmann**
**F-75008 Paris(FR)**

(72) Inventeur: **Berger, Jean-Luc**
**THOMSON-CSF**
**SCPI**
**Cédex 67**
**F-92045 Paris la Défense(FR)**
Inventeur: **Arques, Marc**
**THOMSON-CSF**
**SCPI**
**Cédex 67**
**F-92045 Paris la Défense(FR)**

(74) Mandataire: **Guérin, Michel et al**
**THOMSON-CSF**
**SCPI**
**B.P. 329**
**50, rue Jean-Pierre Timbaud**
**F-92402 Courbevoie Cédex (FR)**

EP 0 364 351 B1

## Description

L'invention concerne les photosenseurs, et plus particulièrement ceux qui sont réalisés sous forme de superposition de couches de silicium amorphe.

Le photosenseur le plus classique en silicium amorphe est une diode de type PIN constituée par la superposition de trois couches semiconductrices, l'une dopée avec une impureté de type P, la suivante non dopée (intrinsèque ou quasi-intrinsèque), et la troisième dopée de type N.

Depuis quelques années, on a aussi proposé des phototransistors à base ouverte dits de type NIPIN réalisés par superposition de cinq couches de silicium amorphe, qui ont une bonne sensibilité la à lumière.

De tels phototransistors ont par exemple été décrits dans la revue IEEE El. Dev. Lett. Vol EDL-8 N°2 Février 1987, pages 64-65.

Ces phototransistors se prêtent bien à la réalisation de matrices de prise de vue adressables en X et Y sur des substrats de grande surface.

Mais ils présentent l'inconvénient d'avoir un courant rémanent après éclairement, et d'autant plus élevé que leur gain est plus élevé. Cela signifie qu'un courant est généré dans le phototransistor pendant son éclairement, et qu'il subsiste assez longtemps après que l'éclairement ait cessé.

Un but de l'invention est de proposer un procédé de détection photoélectrique permettant une réduction de cette rémanence.

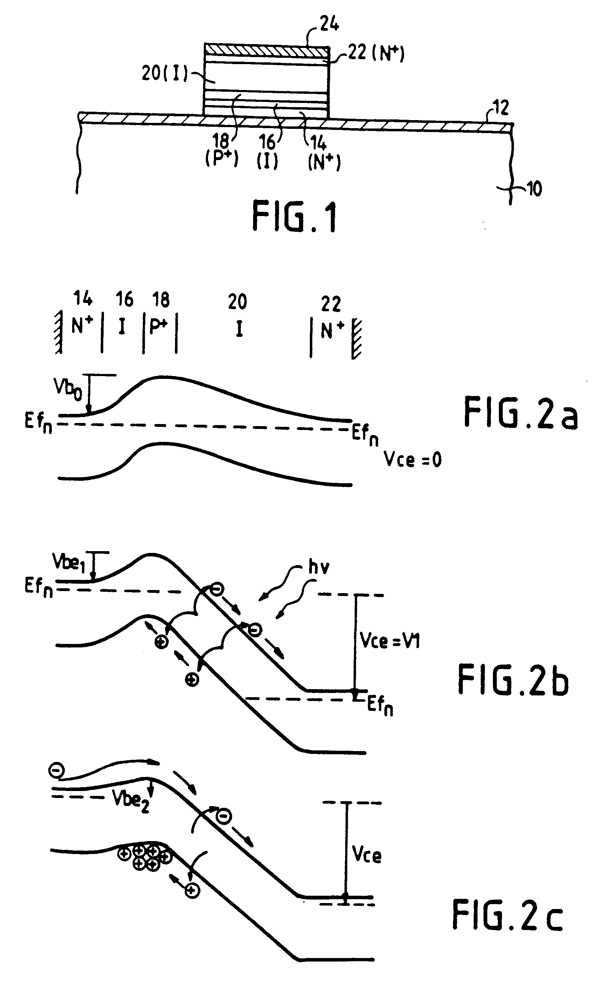

La figure 1 rappelle la structure générale d'un phototransistor de type NIPIN en silicium amorphe : cette structure est un empilement de couches semiconductrices en silicium amorphe sur un substrat 10 qui est généralement en verre.

Plus précisément, on trouve dans l'ordre sur le substrat :

- une couche inférieure conductrice 12 constituant une électrode d'émetteur du phototransistor;
- une mince couche semiconductrice 14 de type N constituant une région d'émetteur du phototransistor;
- une mince couche semiconductrice intrinsèque 16;
- une mince couche semiconductrice 18 de type P, dite couche de base;
- une couche semiconductrice intrinsèque 20 beaucoup plus épaisse que la première couche intrinsèque 16;
- une mince couche semiconductrice 22 de type N constituant une région de collecteur;
- et une couche conductrice 24, constituant une électrode de collecteur.

L'une des électrodes au moins, par exemple l'électrode de collecteur 24, est transparente ou semi-transparente, du côté de la source d'éclairement du phototransistor, .

La couche de base n'est pas connectée à une électrode. Le phototransistor est un transistor "à base en l'air".

Par rapport au substrat l'ordre des couches peut être inversé, le collecteur étant du côté du substrat et les autres couches empilées sur le collecteur (la région de collecteur est celle située du côté de la couche intrinsèque la plus épaisse).

On peut aussi inverser tous les types de conductivité pour réaliser un transistor PINIP, les polarités des tensions d'utilisation étant alors toutes inversées car les porteurs de charge sont alors des trous (alors que ce sont des électrons dans le cas des transistors NIPIN).

Les figures 2a à 2c représentent les niveaux d'énergie potentielle des charges à l'intérieur du semiconducteur, montrant les différentes barrières de potentiel qui se créent et se déforment dans différentes conditions de fonctionnement. Sur ces figures, l'émetteur est à gauche et le collecteur à droite.

A la figure 2a, les niveaux d'énergie sont représentés dans le cas où une différence de potentiel nulle Vec = 0 est appliquée entre le collecteur et l'émetteur du transistor; les niveaux d'énergie sont identiques dans l'émetteur et le collecteur; il existe une barrière de potentiel au milieu : l'énergie croît dans la région intrinsèque la moins épaisse (16) se stabilise dans la couche de base de type P (18) et redescend dans la région intrinsèque plus épaisse (20). La hauteur de la barrière de potentiel est désignée par Vb0.

La figure 2b représente les déformations des niveaux d'énergie lorsque le phototransistor est polarisé en vue d'une utilisation en photodétecteur.

La polarisation est une tension Vec négative de l'émetteur par rapport au collecteur.

La barrière de potentiel entre l'émetteur et la base est abaissée à une valeur Vb1 inférieure à Vb0.

L'abaissement n'est toutefois pas suffisant pour obtenir une injection notable d'électrons de l'émetteur dans la base.

Mais si on éclaire le phototransistor, et notamment la zone intrinsèque du côté du collecteur, il y a génération de paires électrons-trous dans cette zone. Les électrons sont attirés du côté du collecteur et les trous du côté de la base, par suite du champ électrique qui règne dans la zone intrinsèque.

Il y a accumulation de trous dans la base qui n'est pas connectée à une source extérieure. L'accumulation n'est limitée que par la recombinaison des trous et par la diffusion des trous vers l'émetteur. Cette accumulation abaisse encore la barrière de potentiel émetteur-base à une valeur Vb2 pour laquelle la jonction base-émetteur est légèrement polarisée en direct. La figure 2c représente cette situation.

Il y a alors déblocage du transistor et injection d'un flux d'électrons de l'émetteur vers la base; ce flux est supérieur au flux d'électrons généré par la lumière : c'est l'effet phototransistor.

Lorsque l'éclairement cesse, les trous stockés dans la base ne sont pas éliminés instantanément. Ils s'évacuent progressivement par dépiègeage et diffusion vers l'émetteur ou recombinaison. Mais tant qu'ils restent en quantité suffisante, un courant d'électrons injectés par l'émetteur subsiste et est recueilli par le collecteur.

Ce courant constitue un effet de rémanence parasite. L'expérience montre qu'il faut attendre plusieurs dizaines de millisecondes avant qu'il ne disparaisse à 90 ou 95%. Il faut même des temps proches de la seconde pour que le courant d'obscurité retrouve sa valeur minimale.

Ce phénomène de rémanence est beaucoup plus important et donc plus gênant qu'avec une simple photodiode PIN dans laquelle la rémanence n'est due qu'au stockage de porteurs dans des pièges de la zone intrinsèque. Avec le phototransistor il y a ce stockage dans les pièges de la zone intrinsèque et en outre il y a le courant qui continue à être injecté de l'émetteur vers la base.

La solution dans le cas des photodiodes, transposable au cas des phototransistors est d'éclairer en permanence le phototransistor avec une source auxiliaire d'éclairement continu qui se superpose à l'éclairement que l'on veut mesurer.

Cet éclairement constant génère des paires électrons-trous qui viennent remplir les pièges, et notamment les pièges dont les niveaux d'énergie sont les plus profonds; ces derniers sont en effet les plus longs à se vider et ce sont eux qui augmentent le plus l'effet de rémanence.

Lorsque l'éclairement utile (éclairement de signal) cesse, l'éclairement auxiliaire est maintenu et les seuls trous qui doivent disparaître sont ceux qui ont été accumulés par l'éclairement de signal; ceux-là disparaissent rapidement. Les autres restent mais ils n'ont pas besoin d'être évacués car l'état d'équilibre en l'absence d'éclairement de signal prend en compte leur présence : ils existent en présence comme en absence d'éclairement et il suffit de le savoir pour déterminer par différence le signal d'éclairement utile.

L'inconvénient de ce procédé est l'existence d'un photocourant permanent dû à l'éclairement auxiliaire constant. Ce courant est générateur de bruit; de plus, il n'est pas forcément identique d'un phototransistor à un autre dans une même matrice de photosenseurs. Enfin, il nécessite la présence d'une source de lumière auxiliaire, ce qui n'est pas toujours facile à mettre en oeuvre.

La présente invention comme définie dans les revendications a pour but de proposer un nouveau procédé de détection photoélectrique dans lequel on réduit la rémanence, tout particulièrement dans le cas où on utilise comme phototransistor un phototransistor en silicium amorphe, de type NIPIN, ou PINIP.

Le procédé est applicable dans le cas où le phototransistor bipolaire à base flottante est connecté entre une première électrode (électrode de ligne par exemple dans le cas d'un arrangement matriciel) et un noeud flottant, avec un élément de commutation connecté entre le noeud flottant et une deuxième électrode (électrode de colonne). Dans ce cas, le procédé comprend une étape de détection dans laquelle le phototransistor est polarisé en régime non conducteur et l'élément de commutation est bloqué; pendant cette étape on stocke sur le noeud flottant des charges issues du courant de fuite du phototransistor, courant de fuite d'autant plus important que l'éclairement est plus intense. Puis, il y a une étape de lecture pendant laquelle, le phototransistor étant outjours en régime non conducteur, l'élément de commutation est rendu conducteur pour évacuer les charges stockées sur le noeud flottant. Le procédé est caractérisé en ce que, après cette étape de lecture, on effectue une étape d'effacement de rémanence consistant à rendre le phototransistor conducteur.

Un flux d'électrons est alors injecté dans la base et circule entre l'émetteur et le collecteur (dans un sens ou dans un autre comme on le verra); ce flux traverse la base et se recombine avec les trous qui y sont stockés; il traverse par ailleurs les zones intrinsèques et opère aussi une recombinaison des trous qui y sont piégés.

Dans une première mise en oeuvre, le procédé consiste à polariser en direct la jonction collecteur-base du phototransistor par application d'une tension légèrement positive (1 à 2 volts environ) entre l'émetteur et le collecteur (émetteur plus positif que le collecteur pour un transistor NIPIN, le contraire pour un transistor PINIP).

Dans une autre mise en oeuvre qui a l'avantage inattendu de réduire le courant d'obscurité du phototransistor, le procédé consiste à polariser en inverse la jonction collecteur-base, suffisamment pour passer au delà d'un seuil de conduction inverse du phototransistor et pour laisser passer alors un courant non négligeable capable d'évacuer par recombinaison les trous stockés dans la base. La tension appliquée entre l'émetteur et le collecteur est alors relativement élevée (plusieurs volts) et positive du côté du collecteur (pour un transistor NIPIN).

Cette tension est de préférence assez proche du coude de la caractéristique courant-tension (en polarisation inverse) du phototransistor.

Le procédé selon l'invention est tout-à-fait applicable à des phototransistors à base non connectée, la mise en conduction des jonctions émetteur-base et collecteur-base se faisant par application d'une tension entre collecteur et émetteur.

L'élément de commutation, bloqué pendant l'intégration de photocharges et conducteur pendant la lecture de ces charges, est en principe une diode de lecture de capacité nettement plus faible que la capacité du phototransistor. De préférence, cette diode peut être mise en conduction inverse et on utilisera cette propriété pour effectuer un effacement de la rémanence.

Dans une réalisation avantageuse, la diode de lecture présente un premier seuil de mise en conduction dans le sens direct et un deuxième seuil de conduction dans le sens inverse, le phototransistor NIPIN possède aussi un premier seuil de conduction dans le sens direct et un seuil de condcution dans le sens inverse; le phototransistor et la diode de lecture sont en série avec le même sens de conduction directe, et la matrice fonctionne par application d'un cycle de signaux sur les conducteurs de ligne, de la manière suivante :

- on applique d'abord un niveau de tension de repos sur le conducteur de ligne pendant une phase d'intégration de charges dues à l'éclairement de telle manière que le phototransistor soit polarisé en inverse et la diode de lecture ne soit pas mise en conduction directe;

- puis on applique une impulsion de tension, dite impulsion de lecture, d'un premier signe par rapport au niveau de repos et inférieure au seuil de conduction directe du phototransistor de telle manière que la diode de lecture devienne conductrice et une quantité de photocharges soit évacuée vers le conducteur de colonne;

- puis on applique une impulsion de tension du signe opposé, dite impulsion d'effacement de rémanence pour que non seulement la diode de lecture, mais aussi le phototransistor passent en conduction inverse, la différence de potentiel entre le niveau de cette impulsion et le potentiel du conducteur de colonne étant supérieure en valeur absolue à la somme des seuils de mise en conduction inverse du phototransistor et de la diode de lecture.

De préférence, cette différence est assez proche de la somme des seuils de mise en conduction inverse.

De cette manière pendant l'impulsion d'effacement de rémanence, on rend conducteur, en conduction inverse, non seulement la diode de lecture, mais aussi, peu de temps après, le phototransistor lui-même; des électrons sont injectés dans la base et se recombinent avec les trous qui provoquent la rémanence du courant dans le phototransistor.

De préférence, une impulsion de remise à niveau, de signe opposé à l'impulsion d'effacement de rémanence, suit cette dernière, et son amplitude est telle qu'elle permet de refaire passer en conduction directe la diode de lecture. Enfin, l'impulsion de remise à niveau se termine par le retour de la tension de ligne à sa valeur de repos.

La diode de lecture peut être elle-même constituée par une structure à cinq couches de type NIPIN ou PINIP.

Dans la technique antérieure, on notera le brevet US 4,737,832 qui décrit un système de détection à phototransistor. Après une étape de lecture, il y a une étape d'évacuation des charges stockées dans la base du transistor. Mais c'est parce que d'une part les charges photoélectriques engendrées par l'éclairement sont stockées dans la base (et non pas comme dans l'invention sur un noeud flottant connecté au collecteur), et parce que d'autre part l'étape de lecture ne consiste pas à évacuer ces charges : la lecture est non-destructive; il est donc nécessaire de réinitialiser le phototransistor avant une nouvelle phase d'éclairement. Une telle réinitialisation peut être effectuée par une diode à injection connectée à la base du phototransistor (voir EP-A-0 222 624). Dans l'invention, les charges sont stockées sur le collecteur; l'étape de lecture évacue ces charges, mais on constate que la base s'est chargée partiellement, suffisamment pour laisser subsister un effet de rémanence qu'on veut supprimer.

D'autres caractéristiques et avantages de l'invention apparaîtront à la lecture de la description détaillée qui suit et qui est faite en référence aux dessins annexés dans lesquels:

- la figure 1 déjà décrite représente la structure générale d'un phototransistor NIPIN;

- la figure 2 (2a, 2b, 2c), également déjà décrite, représente les niveaux d'énergie des porteurs à l'intérieur des différentes couches semiconductrices dans différentes circonstances;

- la figure 3 représente les caractéristiques courant-tension du phototransistor en présence et en l'absence d'éclairement;

- la figure 4 représente les variations du courant d'obscurité (en valeur absolue) et de la rémanence en fonction de l'amplitude de l'impulsion d'effacement de rémanence que l'on applique selon l'invention au phototransistor;

- la figure 5 représente une matrice de points photosensibles permettant de mettre en oeuvre l'invention;

- la figure 6 représente les diagrammes temporels de potentiels d'un conducteur de ligne et du point de stockage de charges d'un point photosensible de la matrice de la figure 5;
- la figure 7 représente les caractéristiques courant tension du phototransistor et de la diode de lecture au moment de l'opération d'effacement de rémanence selon l'invention.

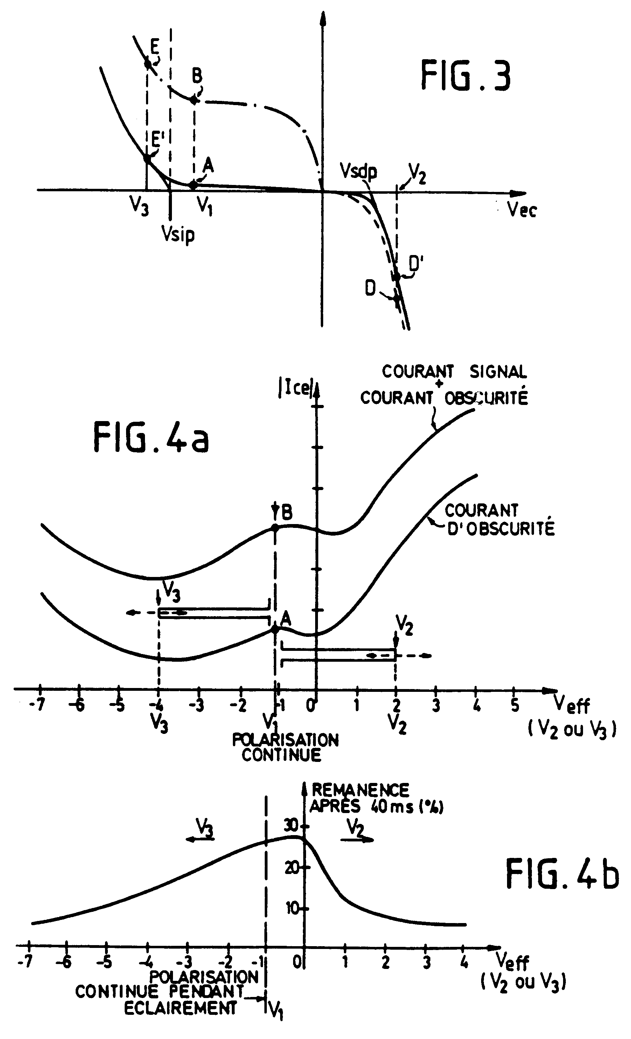

La caractéristique générale courant/tension d'un phototransistor est représentée à la figure 3.

En abscisse on a porté la tension émetteur-collecteur Vec (signe positif du côté émetteur pour un transistor NIPIN); en ordonnée on a porté le courant Ice traversant le phototransistor entre collecteur et émetteur.

La caractéristique en traits pleins est la caractéristique dans l'obscurité; elle présente un seuil de conduction directe Vsdp positif et un seuil de conduction inverse Vsip négatif. Entre le seuil Vsdp et le seuil Vsip, le courant passant dans le phototransistor est un courant faible dit "courant d'obscurité". Au delà des seuils, le phototransistor devient conducteur et laisse passer un courant important.

La caractéristique en traits pointillés représente le courant en présence d'un éclairement. Le courant pour une tension Vec donnée est d'autant plus élevé que l'éclairement est plus fort, même entre les seuils Vsdp et Vsip. La tension de polarisation à laquelle on se place en fonctionnement normal est une tension de polarisation inverse Vec = V1, V1 étant en valeur absolue légèrement en dessous du seuil Vsip. Par polarisation inverse, on entend le fait que la jonction collecteur base du phototransistor est en inverse (collecteur plus positif que l'émetteur pour un transistor NIPIN).

En fonctionnement, le transistor est polarisé au départ dans l'obscurité au point A de la caractéristique en traits pleins. Puis, on éclaire le phototransistor et le point de polarisation se déplace en B. Ce courant est par exemple intégré dans une capacité puis lu dans un amplificateur de lecture.

Une fois que le signal a été lu, on procède selon l'invention à une suppression de la rémanence en appliquant une impulsion de tension d'effacement Veff mettant en conduction le phototransistor.

Dans une première solution, on établit aux bornes du phototransistor une tension V2 de polarisation directe Veff = V2 plus élevée en valeur absolue que le seuil de mise en conduction directe Vsdp. Le point de polarisation se déplace au point D de la caractéristique. Un courant circule de l'émetteur vers le collecteur et traverse la base.

Une recombinaison accélérée de trous a lieu dans la base, supprimant la rémanence.

Puis, le point de polarisation revient vers la caractéristique d'obscurité (point D'); enfin, on applique à nouveau la tension de polarisation V1 pour revenir au point A.

Ce cycle, décrit en supposant que l'éclairement est interrompu entre deux lectures de signal successives, serait semblable si l'éclairement était continu, mais on passerait directement du point D au point B sans passer par le point A.

A l'usage, on observe que ce procédé réduit bien la rémanence de façon sensible, mais il se trouve malheureusement accompagné d'une augmentation notable du courant d'obscurité lorsqu'on retourne à la polarisation V1.

Ce courant n'est que transitoire et indépendant de l'éclairement précédent, mais il introduit des porteurs qui s'additionnent à ceux du signal suivant. On est donc en présence d'un fond continu de signal relativement important superposé au signal utile, ce qui est générateur de bruit, un peu comme dans le procédé classique consistant à essayer de supprimer la rémanence par adjonction d'un éclairement continu superposé au signal.

Ce courant transitoire après conduction du phototransistor peut-être interprété comme une désaturation des pièges de la zone intrinsèque entre base et collecteur. Ces pièges ont en effet été remplis d'électrons lors de l'application de la tension d'effacement Veff = V2. On peut d'ailleurs vérifier expérimentalement que ce courant d'obscurité faisant suite à l'application de la tension V2 est d'autant plus important que l'amplitude de la tension V2 est importante dès lors que cette amplitude dépasse effectivement en valeur absolue l'amplitude de la tension de seuil de mise en conduction directe Vsdp du phototransistor.

En variante de réalisation plus intéressante du point de vue du courant d'obscurité, l'invention propose un cycle de lecture dans lequel l'élimination de la rémanence se fait en appliquant entre collecteur et émetteur du phototransistor une tension d'effacement Veff = V3 non pas directe comme la tension V2, mais inverse, et d'amplitude supérieure en valeur absolue à la tension (Vsip) de seuil de mise en conduction inverse du phototransistor.

Il y a abaissement de la barrière de potentiel émetteur-base et injection d'électrons de l'émetteur vers la base (et non plus du collecteur vers la base). En traversant la base, les électrons se recombinent avec les trous qui y sont accumulés, supprimant ainsi la rémanence.

Dans ce cas, le cycle de lecture et effacement de rémanence fait passer le point de polarisation du phototransistor sur la figure 3 du point A (obscurité) au point B (éclairement) puis au point E (application de la tension d'effacement de rémanence Veff = V3), puis au point E' (suppression de l'éclairement), et enfin au point A (retour à la polarisation normale V1). Comme précédemment, le retour peut se faire directement du point E au point B sans passer par le point E' et le point A si l'éclairement est continu et non interrompu entre deux lectures successives.

Lorsqu'on effectue ainsi l'effacement par application d'une tension inverse supérieure au seuil de mise en conduction inverse du phototransistor, on constate que, au moins pour des valeurs pas trop élevées de la tension V3, le courant d'obscurité diminue avec l'amplitude de V3. D'où l'amélioration par rapport au cas de l'effacement par application d'une tension V2 de mise en conduction directe du phototransistor.

Pour obtenir ce résultat, il faut que le courant d'électrons ne soit pas trop important pendant l'impulsion d'effacement; il faut donc que la tension d'effacement Veff = V3 soit relativement proche du coude de la caractéristique Ice = f(Vec) du phototransistor, c'est-à-dire proche du seuil Vsip.

La figure 4 représente un graphique des variations de l'amplitude du courant d'obscurité transitoire après effacement de la rémanence (graphique 4a) et des variations de la rémanence graphique 4b), en fonction de l'amplitude de la tension d'effacement Veff appliquée (V2 du côté des tensions directes, V3 du côté des tensions inverses).

Sur la figure 4a, les abscisses représentent la valeur de la tension d'effacement; les ordonnées représentent le courant Ice (dans l'obscurité ou en présence d'éclairement de signal) immédiatement après effacement.

Sur la figure 4b, les abscisses représentent encore la valeur de la tension d'effacement; les ordonnées représentent, en pourcentage du signal utile, la rémanence qui subsiste au bout d'un temps déterminé choisi par exemple égal à 40 millisecondes après application de la tension d'effacement.

On voit sur ces graphiques

- d'abord que la situation est plus favorable globalement du côté des tensions d'effacement inverses (V3) puisqu'on peut avoir à la fois une rémanence assez faible et un courant transitoire d'obscurité assez faible,
- ensuite qu'il existe une région optimale, se situant dans l'exemple représenté entre les graduations 4 et 6 à peu près (en abscisse), où on obtient à la fois un courant d'obscurité minimal et une rémanence faible.

On cherchera donc à appliquer une tension d'effacement dans cette région, qui correspond en pratique à une tension d'effacement Veff proche du seuil de conduction inverse Vsip du phototransistor.

Ce procédé d'effacement de rémanence selon l'invention peut s'appliquer dans le cas d'une matrice de points photosensibles chacun constitué par un phototransistor en série avec une diode de lecture. Une telle matrice est décrite dans EP-A-0 331 546. Pour remettre à un niveau de départ constant le potentiel du noeud flottant sur lequel s'accumulent les charges photoélectriques, on applique dans cette demande européene antérieure une impulsion de remise à niveau en sens inverse, qui rend conductrice la diode de lecture en conduction inverse.

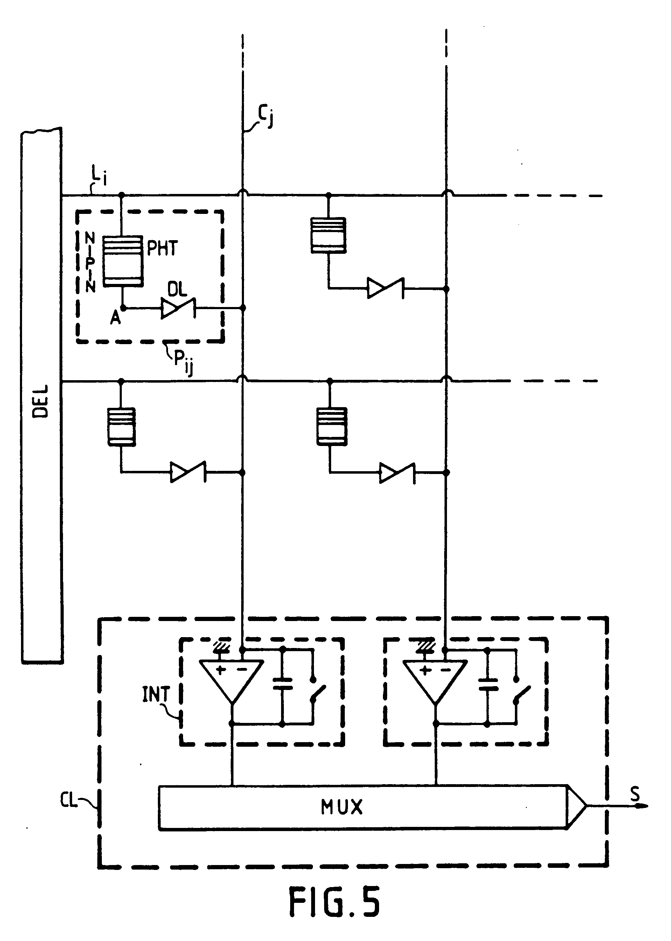

On va maintenant décrire la mise en oeuvre pratique de l'invention à propos d'une telle structure, représentée à la figure 5.

La matrice comprend un réseau de lignes et de colonnes de points photosensibles Pij.

Chaque ligne comprend un conducteur de ligne Li auquel sont raccordés les points photosensibles de cette ligne; le conducteur de ligne Li sert à fournir une tension de repos Vpo pendant une phase d'intégration, puis une impulsion de lecture pendant une phase de lecture, et une impulsion de remise à niveau pendant une phase de remise à niveau avant une nouvelle phase d'intégration. Les conducteurs de ligne sont connectés à un décodeur de ligne DEL apte à sélectionner une ligne déterminée dont on veut lire les points et à fournir les impulsions de lecture et remise à niveau sur cette ligne sélectionnée pendant que les autres lignes sont maintenues à la tension de repos Vpo.

Chaque colonne comprend un conducteur de colonne Cj auquel sont raccordés les points photosensibles de cette colonne; le conducteur de colonne Cj est relié à un circuit CL de lecture des charges générées par le point photosensible Pij situé à l'intersection de cette colonne et de la ligne sélectionnée.

Dans un exemple de réalisation le circuit de lecture comprend un intégrateur INT pour chacune des colonnes de points, et un multiplexeur MUX recevant les sorties des intégrateurs pour fournir sur sa sortie S successivement des signaux représentant l'éclairement des points successifs de la ligne désignée.

Dans d'autres cas le circuit de lecture pourrait être un circuit à transfert de charges et le multiplexeur pourrait être un registe à décalage à transfert de charges.

Chaque point photosensible Pij comprend un phototransistor NIPIN représenté par une structure à cinq couches et désigné par la référence PHT. Cet élément est connecté en série avec un élément de commutation qui est ici une diode de lecture DL, et l'ensemble est relié entre une ligne Li et une colonne Cj.

Le point de jonction A entre le phototransistor et la diode de lecture est le noeud où s'accumulent les charges électriques engendrées par l'éclairement.

La diode de lecture DL, qui permet le transfert de charges du noeud flottant A vers le conducteur de colonne Cj, doit avoir une capacité faible devant celle du phototransistor, ce qui permet que la capacité globale vue d'une colonne soit nettement inférieure à la somme des capacités des phototransistors connectés à cette colonne.

Par ailleurs, la diode de lecture peut être mise en conduction directe si la tension à ses bornes devient supérieure à un premier seuil de tension Vsd dans le sens direct, et elle peut être mise en conduction inverse si la tension à ses bornes devient supérieure à un deuxième seuil de tension Vsi dans le sens inverse.

En d'autres mots, la diode de lecture a une caractéristique courant/tension analogue à celle d'une diode zener. Le collecteur du phototransistor et l'anode de la diode de lecture sont reliés au noeud flottant A. Les deux éléments sont donc connectés en série avec le même sens de conduction (sur la figure 5 : sens de conduction directe du conducteur de ligne vers le conducteur de colonne, pour le phototransistor comme pour la diode).

Les seuils de tension doivent être compatibles avec le fonctionnement des circuits de commande de la matrice. Si la matrice doit fonctionner avec des transistors MOS par exemple, il est souhaitable que les seuils de mise en conduction n'aillent pas en valeur absolue au delà de 12 à 15 volts.

Mais d autre part, l'écart entre le premier seuil et le deuxième seuil doit être suffisamment important car c'est lui qui limitera la dynamique du signal de mesure de l'éclairement.

A titre d'exemple, on sait réaliser des diodes dont la mise en conduction directe a lieu pour un premier seuil de tension positif d'environ + 1volt et dont la mise en conduction inverse a lieu pour un second seuil de tension négatif ajustable entre environ - 8 à - 15 volts par un choix approprié de dopages de couches semiconductrices.

Etant donné qu'il est extrêmement souhaitable que ces seuils soient stables et reproductibles, on choisira de réaliser la diode de lecture DL selon une technologie qui permette d'obtenir cette stabilité et cette reproductibilité. On a remarqué qu'une diode dont la conduction inverse se fait par mise en avalanche d'une jonction n'offre pas toutes les garanties de stabilité et reproductibilité souhaitables; mais un transistor à base ouverte de type NIPIN dont la conduction inverse se fait par abaissement d'une barrière de potentiel, peut servir de diode de lecture ayant de bien meilleures caractéristiques de ce point de vue. Par conséquent on pourra très bien prévoir que la diode de lecture est elle-même un transistor NIPIN (non éclairé de préférence et beaucoup plus petit que le phototransistor). Le côté de ce transistor qui est raccordé au conducteur de colonne est le collecteur (du côté de la couche intrinsèque la plus épaisse) si le phototransistor PHT a lui-même son collecteur relié au point A, et l'autre côté dans le cas contraire.

On va maintenant décrire le fonctionnement de la matrice de la figure 5.

Pour simplifier les explications, on supposera que la capacité de la diode de lecture est négligeable devant celle du phototransistor; s'il n'en était pas ainsi, les valeurs numériques de potentiels et de variations de potentiel indiquées au cours des explications seraient modifiées, mais le principe de fonctionnement resterait valable.

On supposera aussi que le circuit de lecture connecté aux colonnes maintient le potentiel de celles-ci à une valeur de référence nulle.

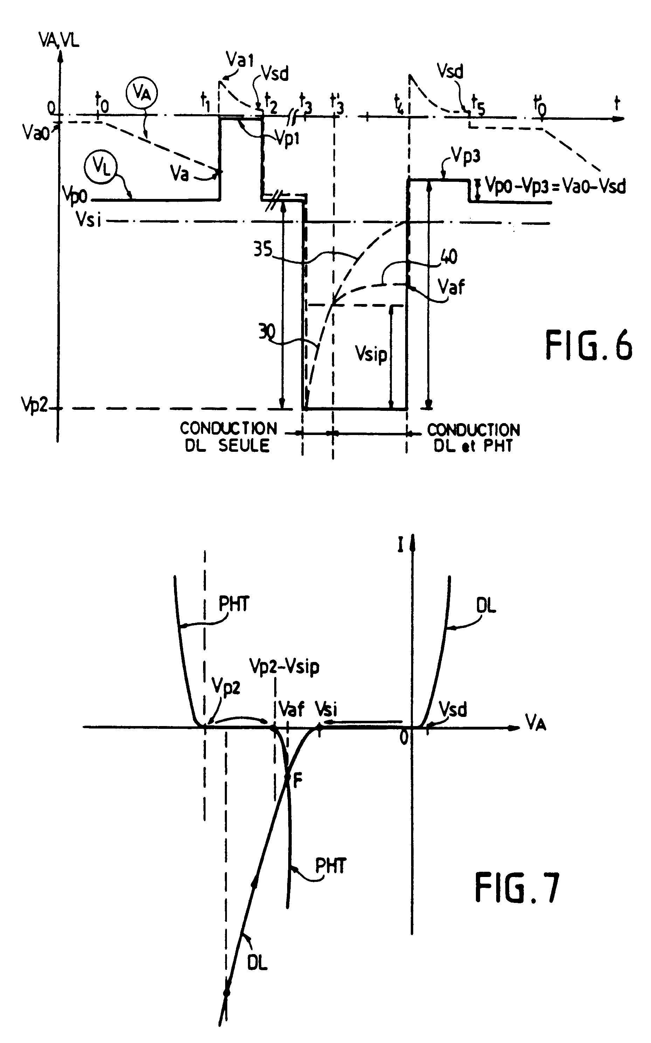

La figure 6 représente des diagrammes temporels permettant d'illustrer le fonctionnement. Les variations du potentiel VL appliqué au conducteur de ligne Li sont représentées en traits pleins; les variations du potentiel VA du noeud A sont représentées en traits tiretés.

Le cycle de fonctionnement périodique dure entre un instant t0 et un instant t'o.

Au départ, juste après l'instant t0, c'est-à-dire juste après qu'on ait ramené le potentiel du conducteur de ligne d'une ligne sélectionnée à sa valeur de repos Vpo, l'état initial est le suivant:

- le potentiel VL sur le conducteur de ligne Li a une valeur de repos Vpo, par exemple -5 volts; la valeur est choisie de telle manière que le phototransistor soit polarisé en inverse même quand le potentiel du noeud A va descendre par suite de l'arrivée de photocharges;
- le potentiel VA sur le noeud A a une valeur VaO nulle ou proche de zéro, en tout cas tel que la diode de lecture ne soit pas mise en conduction directe.
- le potentiel du conducteur de colonne Cj est un potentiel de référence pris par hypothèse égal à zéro.

On verra que c'est bien la situation qui va exister à la fin du cycle de lecture qu'on va maintenant décrire.

Au temps t0 commence une phase d'intégration de charges qui va durer jusqu'au temps t1. On notera que cette phase peut commencer en même temps que se termine la phase précédente, ou au moment où on applique un éclairement de signal (dans le cas où l'éclairement n'est pas continu). On notera aussi que la phase d'intégration de charges se termine soit lorsque cesse l'éclairement (éclairement non continu) soit au début de la phase de lecture qui va suivre la phase d'éclairement. Dans l'exemple représenté, on a choisi de considérer que l'éclairement est continu ; l'accumulation de charges sur le noeud A va donc durer jusqu'au temps t1 où on appliquera une impulsion de lecture.

L'éclairement engendre des charges, qui viennent s'accumuler sur le noeud A sous l'influence du champ électrique dans le phototransistor PHT. Avec les sens de potentiel choisis, compte tenu du sens de connexion de la photodiode, les charges qui s'accumulent sont des électrons.

Le potentiel du noeud A s'abaisse au fur et à mesure de l'arrivée des charges, donc avec une pente de décroissance proportionnelle à l'intensité de l'éclairement.

Au temps t1 se termine la période d'intégration et une impulsion de lecture est appliquée au conducteur de ligne sélectionné, faisant passer son potentiel d'une valeur de repos Vpo à une valeur Vp1.

La valeur Vp1 est choisie pour ne pas mettre en conduction directe le phototransistor, mais suffisamment proche de zéro pour que la dynamique de mesure d'éclairement soit suffisamment élevée. Cette dynamique est en effet liée à la différence de potentiel entre Vp1 et Vpo et cette différence doit être suffisante. En pratique Vp1 est pratiquement égal à zéro, et de toutes façons inférieur au seuil Vsdp de conduction directe du phototransistor.

Par couplage capacitif, l'accroissement brusque de tension sur le conducteur de ligne se transmet au noeud A; le phototransistor est polarisé en inverse et comme sa capacité est beaucoup plus élevée que celle de la diode de lecture, on retrouve au noeud A l'essentiel de l'amplitude du front de montée de l'impulsion de lecture.

Le potentiel du noeud A, qui avait une valeur Va d'autant plus basse que l'éclairement avait été plus fort pendant la phase d'intégration, augmente brusquement d'une valeur (Vp1 - Vpo). Il prend un valeur Va1 = Va + Vp1 - Vpo.

Le potentiel du noeud A était au dessous de zéro et passe au dessus de zéro au temps t1. La diode de lecture devient conductrice et une quantité de charges est évacuée vers le conducteur de colonne; cette quantité représente une mesure de l'éclairement auquel a été soumise la photodiode de t0 à t1; elle est détectée et exploitée par le circuit de lecture CL.

La quantité de charges ainsi transférée sur la colonne est d'autant plus faible que l'éclairement est plus important, ce qui peut être avantageux pour la lecture des faibles éclairements.

L'impulsion de lecture dure suffisamment longtemps pour que la totalité des charges présentes sur le noeud A ait le temps de s'évacuer. Elle se termine au temps t2. Le potentiel du noeud A est alors sensiblement égal à la tension Vsd de conduction directe de la diode de lecture, et la diode de lecture peut alors être considérée comme revenue à l'état bloqué.

La fin de l'impulsion de lecture est un retour à Vp0 du potentiel VL du conducteur de ligne. Ce retour se traduit, par couplage capacitif à travers le phototransistor, par une descente brusque du potentiel du noeud A, qui passe d'environ Vsd à Vsd - Vp1 + Vp0.

Au temps t3 l'impulsion d'effacement de rémanence est appliquée. On pourrait réduire à zéro l'intervalle de temps t2, t3 entre la fin de l'impulsion de lecture et le début de l'impulsion d'effacement de rémanence. Toutefois, on peut aussi conserver un intervalle de temps t2/t3 pendant lequel on va appliquer des impulsions de lecture aux autres lignes de la matrice. Le potentiel VL du conducteur de ligne revient provisoirement à sa valeur de repos Vp0 pendant cet intervalle.

L'impulsion d'effacement de rémanence consiste à faire passer le potentiel VL du conducteur de ligne à une valeur Vp2 telle que le potentiel du noeud A descende, par couplage capacitif, à une valeur assez basse pour que non seulement la diode de lecture, mais aussi le phototransistor passent en conduction inverse.

Là encore, comme le phototransistor présente une capacité beaucoup plus grande que la capacité de la diode de lecture, la variation de potentiel Vp2 - Vp0 est retransmise pratiquement intégralement au noeud A.

Pour expliquer en détail les variations de potentiel au cours de cette étape d'effacement de la rémanence du phototransistor, on se référera à la fois à la figure 6 (diagramme temporel des potentiels du conducteur de ligne et du noeud A) et à la figure 7 qui représente, à un instant particulier de l'effacement de rémanence, entre les instants t3 et t4, les potentiels et courants dans la diode de lecture et le phototransistor.

Au temps t3, le potentiel du noeud A passe à la valeur Vsd -Vp1 + Vp0 + Vp2 - Vp0 c'est-à-dire à Vsd + Vp2 - Vp1.

Cette valeur est fortement négative et supérieure en valeur absolue au seuil de conduction inverse Vsi de la diode de lecture; la diode devient conductrice et tend à ramener à ses bornes une chute de tension égale à environ Vsi. Comme le potentiel de colonne est maintenu imposé à zéro, c'est le potentiel du noeud A qui remonte de la valeur Vsd + Vp2 - Vp1 jusque vers la valeur Vsi (voir la portion de courbe tiretée 30 sur la figure 6).

Pendant ce temps le potentiel du conducteur de ligne reste à Vp2. L'écart de tension entre le potentiel du noeud A et le potentiel du conducteur de ligne augmente donc rapidement. Au temps t'3, on constate que cet écart atteint la valeur Vsip qui est le seuil de conduction inverse du phototransistor, alors que la diode de lecture est toujours largement en conduction inverse.

Si on se réfère à la figure 6, cela est possible à condition qu'on ait choisi le potentiel Vp2 de l'impulsion d'effacement de rémanence supérieur en valeur absolue à la somme des seuils de conduction inverse du phototransistor et de la diode (Vsi + Vsip).

Le phototransistor devient alors conducteur en conduction inverse et tend à maintenir entre ses bornes une tension Vsip ou légèrement supérieure en valeur absolue à Vsip. Par conséquent, au lieu que le potentiel du noeud A continue à tendre vers la valeur Vsi (courbe en pointillés 35 qu'il suivrait si le phototransistor ne devenait pas conducteur), il se stabilise à une valeur qui est légèrement inférieure, en valeur absolue, à Vp2 - Vsip (portion de courbe 40 sur la figure 6).

Pendant la phase correspondant à la courbe 40, à la fois la diode et le phototransistor sont en conduction inverse. Comme ces éléments sont en série, ils tendent à être parcourus par un même courant; c'est pourquoi on a représenté à la figure 7 les caractéristiques courant-tension de ces deux éléments, la référence de potentiel étant
- pour la diode le potentiel nul du conducteur de colonne auquel elle est reliée,
- et pour le phototransistor le potentiel Vp2 du conducteur de ligne auquel il est relié.

Plus précisément, la figure 7 représente le courant traversant le phototransistor et la diode de lecture en fonction du potentiel du noeud A, entre les instants t'3 et t4.

Les caractéristiques se coupent en un point de fonctionnement F pour lequel les courants dans la diode et dans le phototransistor sont identiques.

Le potentiel du noeud A reste ensuite sensiblement à ce point de fonctionnement F jusqu'à la fin de l'impulsion d'effacement de rémanence. Comme on le voit aisément sur la figure 6 et sur la figure 7, le potentiel Vaf de ce point de fonctionnement est compris entre Vsi et Vp2 - Vsi.

Selon une caractéristique importante de l'invention, on s'arrange pour que le potentiel Vaf de ce point soit assez proche de Vp2 - Vsip, en choisissant le potentiel Vp2 assez proche de Vsi + Vsip.

La mise en conduction du phototransistor à partir du temps t'3 et jusquau temps t4 (fin de l'impulsion d'effacement) a pour effet de faire circuler un courant d'électrons dans sa base et donc d'éliminer par recombinaison les trous qui sont source de rémanence. Le choix du potentiel Vp2 à une valeur proche de Vsi + Vsip permet de minimiser le courant d'obscurité transitoire qui suit l'effacement de la rémanence. Il faut évidemment que l'intervalle de temps t'3/t4 (et par conséquent t3/t4) soit suffisamment long pour que la recombinaison des porteurs stockés dans la base ait le temps de se produire.

Le cycle se poursuit de préférence en appliquant au temps t4 une impulsion de remise à niveau de signe opposé à l'impulsion d'effacement, et d'amplitude suffisante pour faire remonter le potentiel du noeud A au dessus de zéro; cela permet de rendre conductrice, en direct cette fois, la diode de lecture, et de ramener par conséquent le potentiel du noeud A à une valeur de l'ordre de Vsd.

Enfin, l'impulsion de remise à niveau se termine au temps t5 par un retour du potentiel de ligne VL à sa valeur initiale de repos Vp0. Lors de ce retour, il faut que le noeud A repasse alors aussi, par couplage capactitif, à sa valeur initiale VaO. Cela veut dire que l'amplitude du saut de potentiel final de retour de VL vers Vp0 doit être égale à Va0 - Vsd. Cela veut donc dire que le niveau de tension Vp3 de l'impulsion de remise à niveau est tel que Vp0 - Vp3 = Va0 - Vsd.

Pour que la diode de lecture repasse effectivement en conduction directe pendant l'impulsion de remise à niveau, il est nécessaire par ailleurs que le saut de tension Vp3 - Vp2 amène par couplage capacitif le potentiel du noeud A au dessus du seuil Vsd. Or le potentiel du noeud A à la fin de l'impulsion d'effacement de rémanence est Vaf (compris entre Vsi et Vp2 - Vsip.

Il est donc nécessaire que Vp3 - Vp2 soit supérieur à Vsd - Vaf.

Ces différentes contraintes permettent de choisir correctement les différentes valeurs des potentiels du conducteur de ligne pour aboutir au résultat cherché. Le potentiel Vp2 sera ajusté de manière à optimiser la position du point F (figure 7), c'est-à-dire du potentiel Vaf, pour aboutir au meilleur compromis possible entre l'effacement de la rémanence et la réduction du courant d'obscurité postérieur à cet effacement.

Un nouveau cycle d'intégration recommence au temps t'0 lorsqu'on éclaire à nouveau la matrice. Le temps t'0 peut être confondu avec le temps t5; il est obligatoirement confondu avec t5 lorsque l'éclairement de signal est continu.

Dans le cycle d'intégration / lecture / effacement de rémanence / remise à niveau, on prévoira qu'il est nécessaire de lire, effacer et remettre à niveau les points photosensibles des autres lignes de la matrice. On peut prévoir par exemple que l'intervalle de temps entre t2 (fin de la lecture) et t3 (effacement de rémanence) est suffisamment long pour permettre d'appliquer des impulsions de lecture successivement à toutes les lignes de la matrice. Les impulsions d'effacement de rémanence et de remise à niveau peuvent alors être appliquées simultanément à toutes les lignes de la matrice.

Mais on pourrait prévoir aussi d'autres solutions comme une lecture un effacement de rémanence et une remise à niveau pour une ligne, puis une lecture, un effacement de rémanence et une remise à niveau pour une ligne suivante, etc.

## Revendications

1. Procédé de détection photoélectrique, dans lequel on utilise comme élément de détection un phototransistor bipolaire (PHT) à base flottante connecté entre une première électrode (Li) et un noeud flottant (A) de stockage de charges, avec un élément de commutation (DL) connecté entre le noeud flottant et une deuxième électrode (Cj), le procédé comprenant une étape de détection dans laquelle on polarise le phototransistor (PHT) en régime non conducteur et on stocke sur le noeud flottant (A) des charges photoélectriques engendrées dans le phototransistor, et une étape de lecture dans laquelle on rend conducteur l'élément de commutation (DL) et on évacue les charges stockées, caractérisé en ce que, après l'étape de lecture, on effectue une étape d'effacement de rémanence consistant à rendre le phototransistor (PHT) conducteur.

2. Procédé selon la revendication 1, caractérisé en ce que la mise en conduction pendant l'étape d'effacement de rémanence est effectuée par application d'une impulsion de tension élevée (V2, V3) entre collecteur (22) et émetteur (14).

3. Procédé selon la revendication 2, caractérisé en ce que l'impulsion de tension (V2) est appliquée en polarisation directe injectant des charges de l'émetteur (14) vers la base (18).

4. Procédé selon la revendication 2, caractérisé en ce que l'impulsion de tension (V3) est appliquée en polarisation inverse injectant des charges du collecteur (22) vers la base (18), la polarisation étant suffisamment élevée pour faire passer le phototransistor au delà d'un seuil de conduction inverse (Vsip).

5. Procédé selon la revendication 4, caractérisé en ce que la tension de polarisation inverse (V3) pendant l'étape d'effacement de la rémanence est proche de la tension de seuil de conduction inverse (Vsip) du phototransistor.

6. Procédé selon l'une des revendications 1 à 5, caractérisé en ce que le phototransistor est un phototransistor en silicium amorphe à cinq couches superposées NIPIN (14, 16, 18, 20, 22) ou PINIP.

7. Procédé d'effacement de la rémanence d'une matrice photosensible dont chaque point photosensible (Pij) comprend un phototransistor bipolaire (PHT) à base flottante comme élément photodétecteur et une diode de lecture (DL) connectée en série avec le même sens de conduction avec ce dernier entre un conducteur de ligne (Li) et un conducteur de colonne (Cj) de la matrice, la diode de lecture et le phototransistor pouvant être mis en conduction inverse, comprenant les étapes suivantes:
   - on applique d'abord un niveau de tension de repos (Vp0) sur le conducteur de ligne pendant une phase d'intégration de charges dues à l'éclairement de telle manière que le phototransistor (PHT) soit polarisé en inverse et la diode de lecture (DL) ne soit pas mise en conduction directe;
   - puis on applique une impulsion de tension (Vp1), dite impulsion de lecture, d'un premier signe par rapport au niveau de repos et inférieure au seuil de conduction directe (Vsdp) du phototransistor de telle manière que la diode de lecture devienne conductrice et une quantité de photocharges soit évacuée vers le conducteur de colonne (Cj);
   - puis on applique une impulsion de tension (Vp2) du signe opposé, dite impulsion d'effacement de rémanence pour que non seulement la diode de lecture, mais aussi le phototransistor passent en conduction inverse, la différence de potentiel entre le niveau de cette impulsion et le potentiel du conducteur de colonne étant supérieure en valeur absolue à la somme des seuils de mise en conduction inverse (Vsip et Vsi) du phototransistor et de la diode de lecture.

8. Procédé selon le revendication 7, caractérisé en ce que la différence de potentiel entre le niveau de l'impulsion d'effacement (Vp2) et le potentiel du conducteur de colonne est proche de la somme (Vsi + Vsip) des seuils de mise en conduction inverse de la diode de lecture (DL) et du phototransistor (PHT).

9. Procédé selon l'une des revendications 7 et 8, caractérisé en ce que l'impulsion d'effacement (Vp2) est suivie d'une impulsion de remise à niveau (Vp3) d'amplitude suffisante pour remettre en conduction directe la diode de lecture (DL).

10. Procédé selon l'une des revendications 7 à 9, caractérisé en ce que les impulsions de lecture (Vp1) sont appliquées successivement sur les différentes lignes (Li) de la matrice, et en ce que les impulsions d'effacement de rémanence (Vp2) sont appliquées simultanément pour toutes les lignes (Li), un intervalle de temps (t2, t3) étant prévu entre la fin de l'impulsion de lecture et le début de l'impulsion d'effacement de rémanence.

11. Procédé selon l'une des revendications 7 à 10, caractérisé en ce que la diode de lecture (DL) est réalisée sous forme d'un transistor à base flottante de type NIPIN (14, 16, 18, 20, 22) ou PINIP.

## Claims

1. A photoelectric detector method, wherein a floating base bipolar phototransistor (PHT) is employed which is interconnected between a first electrode (Li) and a floating node (A) for storing charges, comprising a switch element (DL) interconnected between the floating node and a second electrode (Cj), the method including a detection phase during which the phototransistor (PHT) is biased in a non-conductive state and in which photoelectric charges produced in the phototransistor are stored on the floating node (A), and a read-out phase in which the switch element (DL) is rendered conductive and the stored charges are extracted, characterized in that after the read-out phase a remanence elimination phase is performed which consists in rendering the phototransistor (PHT) conductive.

2. A method according to claim 1, characterized in that the phototransistor is rendered conductive during the remanence elimination phase by applying a high voltage pulse (V2, V3) between the collector (22) and the emitter (14).

3. A method according to claim 2, characterized in that the voltage pulse (V2) is applied in direct polarization, thus injecting charges from the emitter (14) to the base (18).

4. A method according to claim 2, characterized in that the voltage pulse (V3) is applied in inverted polarization, thus injecting charges from the collector (22) to the base (18), the biasing being sufficiently high to allow the phototransistor to operate beyond the inverse conduction threshold (Vsip).

5. A method according to claim 4, characterized in that the inverse polarization voltage (V3) during the remanence elimination phase is close to the inverse conduction threshold voltage (Vsip) of the phototransistor.

6. A method according to one of claims 1 to 5, characterized in that the phototransistor is of the amorphous silicon type having five superimposed layers according to the structure NIPIN (14, 16, 18, 20, 22) or PINIP.

7. A remanence elimination method for a photosensitive matrix whose photosensitive points (Pij) each comprise a floating base bipolar phototransistor (PHT) as photodetector element and a read-out diode (DL) series-connected with the phototransistor along the same conduction direction between a line conductor (Li) and a column conductor (Cj) of the matrix, the read-out diode and the phototransistor being conceived to be put into the inverse conduction mode, the method comprising the following phases:
   - firstly, a stand-by voltage level (Vp0) is applied to the line conductor during a charge integration phase due to the incident light such that the phototransistor (PHT) is biased inversely and the read-out diode (DL) is not in the direct conduction mode,
   - then, a read-out voltage pulse (Vp1) is applied, having a first polarity with respect to the stand-by level and remaining below the direct conduction threshold (Vsip) of the phototransistor such that the read-out diode becomes conductive and a quantity of photocharges is extracted towards the column conductor (Cj),
   - then, a voltage pulse (Vp2) of opposite polarity, referred to as remanence elimination pulse, is applied, such that not only the read-out diode but also the phototransistor operates in the inverse conduction mode, the potential difference between the amplitude of this pulse and the potential of the column conductor exceeding in absolute values the sum of the thresholds of inverse conductivity (Vsip + Vsi) of the phototransistor and the read-out diode.

8. A method according to claim 7, characterized in that the potential difference between the remanence elimination pulse level (Vp2) and the potential of the column conductor is close to the sum (Vsi + Vsip) of the inverse conduction thresholds of the read-out diode (DL) and the phototransistor (PHT).

9. A method according to one of claims 7 and 8, characterized in that the remanence elimination pulse (Vp2) is followed by a level restitution pulse (Vp3) whose amplitude is sufficient for putting the read-out diode (DL) back into the direct conduction mode.

10. A method according to one of claims 7 to 9, characterized in that read-out pulses (Vp1) are successively applied to the different lines (Li) of the matrix and that the remanence elimination pulses (Vp2) are simultaneously applied to all the lines (Li), a time interval (t2 - t3) being provided between the end of the read-out pulse and the beginning of the remanence elimination pulse.

11. A method according to one of claims 7 to 9, characterized in that the read-out diode (DL) is constituted by a floating base transistor of the NIPIN (14, 16, 18, 20, 22) or PINIP type.

**Patentansprüche**

1. Photoelektrisches Detektorverfahren, bei dem man als Detektorelement einen bipolaren Phototransistor (PHT) mit frei schwebender Basis verwendet, der zwischen eine erste Elektrode (Li) und einen frei schwebenden Knoten (A) zur Ladungsspeicherung eingefügt ist, mit einem Schaltelement (DL), das zwischen den frei schwebenden Knoten und eine zweite Elektrode (Cj) eingefügt ist, wobei das Verfahren eine Detektorphase, in der der Phototransistor (PHT) so vorgespannt ist, daß er nicht leitet, und in der der frei schwebende Knoten (A) im Phototransistor erzeugte photoelektrische Ladungen speichert, und eine Lesephase enthält, in der man das Schaltelement (DL) leitend macht und die gespeicherten Ladungen abführt, dadurch gekennzeichnet, daß nach der Lesephase eine Remanenzlöschphase folgt, die darin besteht, den Phototransistor (PHT) leitend zu machen.

2. Verfahren nach Anspruch 1, dadurch gekennzeichnet, daß der Phototransistor während der Remanenzlöschphase leitend gemacht wird, indem ein Impuls hoher Spannung (V2, V3) zwischen Kollektor (22) und Emitter (14) angelegt wird.

3. Verfahren nach Anspruch 2, dadurch gekennzeichnet, daß der Spannungsimpuls (V2) in Leitrichtung gepolt ist und Ladungen vom Emitter (14) zur Basis (18) injiziert.

4. Verfahren nach Anspruch 2, dadurch gekennzeichnet, daß der Spannungsimpuls (V3) in Sperrichtung gepolt ist und Ladungen vom Kollektor (22) zur Basis (18) injiziert, wobei die Vorspannung ausreichend hoch ist, um den Phototransistor in Sperrichtung (Vsip) bis jenseits einer Leitschwelle zu bringen.

5. Verfahren nach Anspruch 4, dadurch gekennzeichnet, daß die Vorspannung (V3) in Sperrichtung während der Remanenzlöschphase in der Nähe der Leitschwelle (Vsip) des Phototransistors in Sperrichtung liegt.

6. Verfahren nach einem der Ansprüche 1 bis 5, dadurch gekennzeichnet, daß der Phototransistor aus amorphem Silizium besteht und fünf übereinanderliegende Schichten vom Typ NIPIN (14, 16, 18, 20, 22) oder PINIP besitzt.

7. Remanenzlöschverfahren für eine lichtempfindliche Matrix, deren einzelne lichtempfindliche Punkte (Pij) je einen bipolaren Phototransistor (PHT) mit frei schwebender Basis als Photodetektorelement sowie eine Lesediode (DL) besitzen, die in Reihe und in gleicher Leitrichtung mit dem Phototransistor zwischen einem Zeilenleiter (Li) und einem Spaltenleiter (Cj) der Matrix angeschlossen ist, wobei die Lesediode und der Phototransistor in Sperrichtung leitend gesteuert werden können und das Verfahren folgende Phasen aufweist:
    - man legt zuerst einen Ruhespannungspegel (Vp0) an den Zeilenleiter während einer Ladungsintegrationsphase aufgrund des Lichteinfalls, derart, daß der Phototransistor (PHT) in Sperrichtung vorgespannt ist und die Lesediode (DL) nicht in Leitrichtung leitend ist,
    - dann legt man einen Spannungsimpuls (Vp1), Leseimpuls genannt, eines ersten Vorzeichens bezüglich eines Ruhepegels und einer kleineren Amplitude als die Leitschwelle (Vsdp) des Phototransistors in Leitrichtung an, so daß die Lesediode leitend wird und eine Photoladungsmenge zum Spaltenleiter (Cj) abfließt,
    - dann legt man einen Spannungsimpuls (Vp2) entgegengesetzten Vorzeichens, Remanenzlöschimpuls genannt, an, um nicht nur die Lesediode, sondern auch den Phototransistor in den Leitzustand in Sperrichtung zu steuern, wobei die Potentialdifferenz zwischen dem Pegel dieses Impulses und dem Potential des Spaltenleiters in Absolutwerten größer als die Summe der Leitschwellen (Vsip + Vsi) des Phototransistors und der Lesediode in Sperrichtung ist.

8. Verfahren nach Anspruch 7, dadurch gekennzeichnet, daß die Potentialdifferenz zwischen dem Pegel des Löschimpulses (Vp2) und dem Potential des Spaltenleiters in der Nähe der Summe der Leitschwellen (Vsi + Vsip) der Lesediode (DL) und des Phototransistors (PHT) in Sperrichtung liegt.

9.  Verfahren nach einem der Ansprüche 7 und 8, dadurch gekennzeichnet, daß auf den Remanenzlöschimpuls (Vp2) ein Pegelrücksetzimpuls (Vp3) folgt, dessen Amplitude ausreicht, um die Lesediode (DL) wieder in den Leitbereich in Leitrichtung zu bringen.

10. Verfahren nach einem der Ansprüche 7 bis 9, dadurch gekennzeichnet, daß die Leseimpulse (Vp1) nacheinander an die verschiedenen Zeilen (Li) der Matrix angelegt werden und daß die Remanenzlöschimpulse (Vp2) gleichzeitig an alle Zeilen (Li) angelegt werden, wobei ein Zeitintervall (t2 - t3) zwischen dem Ende des Leseimpulses und dem Beginn des Remanenzlöschimpulses vorgesehen ist.

11. Verfahren nach einem der Ansprüche 7 bis 10, dadurch gekennzeichnet, daß die Lesediode (DL) als Transistor mit frei schwebender Basis vom Typ NIPIN (14, 16, 18, 20, 22) oder PINIP ausgebildet ist.

FIG.1

FIG.2a

FIG.2b

FIG.2c

EP 0 364 351 B1

FIG.3

FIG.4a

COURANT SIGNAL
+
COURANT OBSCURITÉ

COURANT
D'OBSCURITÉ

POLARISATION
CONTINUE

FIG.4b

REMANENCE
APRÈS 40ms (%)

POLARISATION
CONTINUE PENDANT
ECLAIREMENT

FIG.5

FIG.6

FIG.7